# FASCICULE DE BREVET EUROPEEN

(11) **EP 3 958 004 B1**
(45) Date de publication et mention de la délivrance du brevet: **05.08.2026**
(21) Numéro de dépôt: 21198889.4
(22) Date de dépôt: 29.10.2018
(51) Int. Cl.: G01R 31/327, H02H 3/04, H02H 3/05, H02H 3/33, G01R 31/50

(54) **PROCÉDÉ DE TEST DE PROTECTION DIFFÉRENTIELLE, DISPOSITIF DE PROTECTION DIFFÉRENTIELLE ET APPAREIL ÉLECTRIQUE COMPORTANT UN TEL DISPOSITIF**
VERFAHREN ZUM TEST DES DIFFERENTIALSCHUTZES, DIFFERENTIALSCHUTZVORRICHTUNG UND ELEKTRISCHES GERÄT, DAS EINE SOLCHE VORRICHTUNG UMFASST
METHOD FOR TESTING DIFFERENTIAL PROTECTION, DIFFERENTIAL PROTECTION DEVICE AND ELECTRICAL APPARATUS COMPRISING SUCH A DEVICE

(30) Priorité: 19.12.2017 FR 1762429
(43) Date de publication de la demande: 23.02.2022
(62) Demande divisionnaire de: 18203016.3
(73) Titulaire: Schneider Electric Industries SAS, 92500 Rueil-Malmaison (FR)
(72) Inventeur: BERNARD, Jean-Baptiste, 38050 GRENOBLE (FR); VINCENT, François, 38050 GRENOBLE (FR); TIAN, Simon, 38050 GRENOBLE (FR); MEUNIER-CARUS, Jérôme, 38050 GRENOBLE (FR)
(74) Mandataire: Lavoix

(56) Documents cités:
- EP-A1- 0 814 555
- WO-A1-2012/040750
- US-A1- 2009 251 148
- US-A1- 2010 295 568

## Description

### DOMAINE TECHNIQUE

L'invention concerne un procédé de test de protection différentielle ayant une première chaine de protection différentielle, une seconde chaine de protection différentielle, et une unité de traitement.

L'invention concerne aussi un dispositif de protection différentielle comportant :
- une première chaine de protection différentielle,
- une seconde chaine de protection différentielle,
- un dispositif de test pour tester lesdites chaines de protection différentielle, et
- une unité de traitement connectée à la seconde chaine de protection différentielle.

L'invention concerne aussi un appareil de protection électrique comportant des contacts principaux, un mécanisme d'ouverture desdits contacts principaux, des conducteurs principaux connectés en série avec lesdits contacts principaux et un dispositif de protection différentielle ayant au moins deux chaines de protection différentielle.

### ETAT DE LA TECHNIQUE

Il est connu d'utiliser l'injection de signaux pour tester des dispositifs de protection différentielle. Le but de ces tests est de vérifier le fonctionnement de la chaine de mesure et de déclenchement. La plupart des tests consistent à générer un signal de défaut différentiel et à constater le déclenchement ou l'ouverture d'un appareil électrique.

WO 2012/040750 A1 et US 2010/295568 A1 décrivent des exemples de dispositifs de protection différentielle comportant des moyens de test.

Les dispositifs de test connus ne sont pas suffisants pour tester des dispositifs de protection différentiels complexes à plusieurs chaines de protection différentielle. Souvent, ces dispositifs complexes comportent une première chaine de protection à propre courant sans nécessité d'alimentation électrique extérieures et une seconde chaine plus complète en circuits électroniques nécessitant une alimentation électrique. Généralement, la première chaine détecte les défauts en courant alternatifs ou pulsés, et la seconde chaine permet de détecter des défauts en courants continus, alternatifs ou pulsés.

Les circuits de test classiques injectent ou font circuler dans des tores de mesure un signal ou courant de défaut différentiel. Puis les chaines de traitement détectent le défaut et provoquent le déclenchement de l'ouverture d'un appareil électrique tel qu'un interrupteur ou un disjoncteur. Dans ce cas, lors du test, il suffit qu'une seule chaine de protection fonctionne pour faire déclencher. Par conséquent, le test n'est pas complet et ne reflète pas le bon fonctionnement total de l'ensemble des chaines de protection différentielle.

### EXPOSE DE L'INVENTION

L'invention, telle que définie par le jeux des revendications ici-dessous, a pour but un procédé de test et un dispositif de protection différentielle ayant un test amélioré des chaines de protection différentielles.

Selon l'invention, un procédé de test de protection différentielle ayant une première chaine de protection différentielle, une seconde chaine de protection différentielle, et une unité de traitement comporte :
- une étape de commande de la circulation ou d'injection d'un signal de test de la protection différentielle pendant une durée prédéterminé inférieure à un temps de non déclenchement de ladite première et de ladite seconde chaines de protection différentielle,
- des étapes de détermination d'un état de ladite première et de ladite seconde chaine de protection différentielle après circulation d'un signal de test, de contrôle de la conformité de l'évolution des chaines de protection, et de détermination de l'état du test, et
- une étape de déclenchement ou de signalisation si le test est satisfaisant.

Selon l'invention, ladite seconde chaine de protection différentielle nécessitant une alimentation électrique est associée à l'unité de traitement, et le procédé comporte pendant la phase de test une étape d'inhibition ou de sélection de déclenchement long de la seconde chaine de protection différentielle avant la commande de circulation ou d'injection dudit signal de test.

De préférence, lors d'étapes de détermination de l'état de ladite première chaine de traitement différentielle, le procédé contrôle un composant de temporisation ou de filtrage de ladite première chaine de protection différentielle ne nécessitant pas d'alimentation électrique.

Selon l'invention, le procédé comporte une étape de détection de l'action sur un organe de commande du test pour lancer manuellement un cycle de test et/ou des étapes pour lancer automatiquement de manière périodique ledit cycle de test. De préférence, le procédé comporte une étape de réinitialisation d'une partie numérique de l'unité de traitement si l'état du test n'est pas conforme.

Selon l'invention, dans un dispositif de protection différentielle comportant :
- une première chaine de protection différentielle,
- une seconde chaine de protection différentielle,
- un dispositif de test pour tester lesdites chaines de protection différentielle, et
- une unité de traitement connectée à des modules de la seconde chaine de protection différentielle pour recevoir un signal représentatif du traitement de la dite seconde chaine,

ladite unité de traitement :
- est connectée aussi à la première chaine de protection différentielle pour recevoir un signal représentatif de la protection différentielle et pour déterminer l'état de la protection de ladite première chaine,
- comporte une sortie pour commander la circulation d'un signal ou d'un courant de test pendant une durée prédéterminé inférieure à un temps de non déclenchement de ladite première et de ladite seconde chaines de protection différentielle,
- comporte des modules pour contrôler l'évolution des chaines de protection et détermine l'état du test, et
- commande le déclenchement de l'ouverture d'un appareil électrique ou une signalisation si le test est bon.

Avantageusement, l'unité de traitement comporte des modules pour déterminer l'état de ladite première chaine et de ladite seconde chaine de protection différentielle avant la circulation d'un signal ou courant de test et pour commander le dispositif de test en fonction de l'état de la première et de la seconde chaine de protection différentielle.

Avantageusement, la première chaine de protection différentielle est une chaine fonctionnant en courant de défaut alternatif ou pulsé ne nécessitant pas d'alimentation électrique pour son propre fonctionnement.

Selon l'invention, la seconde chaine de protection différentielle fonctionne pour des courants de défaut continus, alternatifs ou pulsés et est alimentée par une alimentation électrique, ladite unité de traitement étant associée à ladite seconde chaine de protection différentielle pour le traitement de la protection différentielle.

De préférence, la première chaine de protection différentielle comporte un composant de temporisation ou de filtrage, ledit composant étant connecté à l'unité de traitement pour fournir un signal représentatif de l'état de la première chaine de protection différentielle.

Selon l'invention, le dispositif de protection différentielle comporte un organe de commande du test connecté à l'unité de traitement pour commander manuellement un cycle de test.

Avantageusement, un déclenchement de l'ouverture d'un appareil est réalisé par une commande pendant un temps de circulation d'un courant de test supérieur à un temps de déclenchement de la première chaine de protection ou de la seconde chaine de protection.

Avantageusement, un déclenchement de l'ouverture d'un appareil est réalisé par une commande directe d'un relais de déclenchement par ladite unité de traitement ou par une sortie de l'unité de traitement commandant la charge d'un condensateur utilisé aussi pour un stockage de l'énergie électrique de commande dudit relais de déclenchement.

Avantageusement, dans un appareil de protection électrique comportant des contacts principaux, un mécanisme d'ouverture desdits contacts principaux, des conducteurs principaux connectés en série avec lesdits contacts principaux et un dispositif de protection différentielle ayant au moins deux chaines de protection différentielle, ledit dispositif de protection différentielle est un dispositif tel que défini ci-dessus comportant des capteurs de courant pour lesdites chaines de protection différentielle entourant lesdits conducteurs principaux et fournissant des signaux représentatifs de courants de défaut différentiel, ledit mécanisme d'ouverture étant actionné par un relais de déclenchement en cas de détection de défaut différentiel ou de test concluant des dites chaines de protection différentielle.

### BREVE DESCRIPTION DES DESSINS

D'autres avantages et caractéristiques ressortiront plus clairement de la description qui va suivre, de modes particuliers de réalisation de l'invention, donnés à titre d'exemples non limitatifs, et représentés aux dessins annexés sur lesquels :
- la figure 1 représente un schéma bloc d'un appareil électrique comportant un dispositif de protection différentiel selon l'art antérieur ;
- la figure 2 représente un schéma bloc d'un appareil électrique comportant un dispositif de protection différentiel selon un premier mode de réalisation de l'invention ;
- la figure 3 représente un schéma bloc d'un appareil électrique comportant un dispositif de protection différentiel selon un second mode de réalisation de l'invention ;
- les figures 4A à 4D représentent des chronogrammes de signaux dans un dispositif de protection différentiel selon des modes de réalisation de l'invention ;
- la figure 5 représente un premier organigramme de test de protection différentielle selon un mode de réalisation de l'invention ; et
- la figure 6 représente un second organigramme de test de protection différentielle selon un mode de réalisation de l'invention.

### DESCRIPTION DETAILLEE DE MODES DE REALISATION

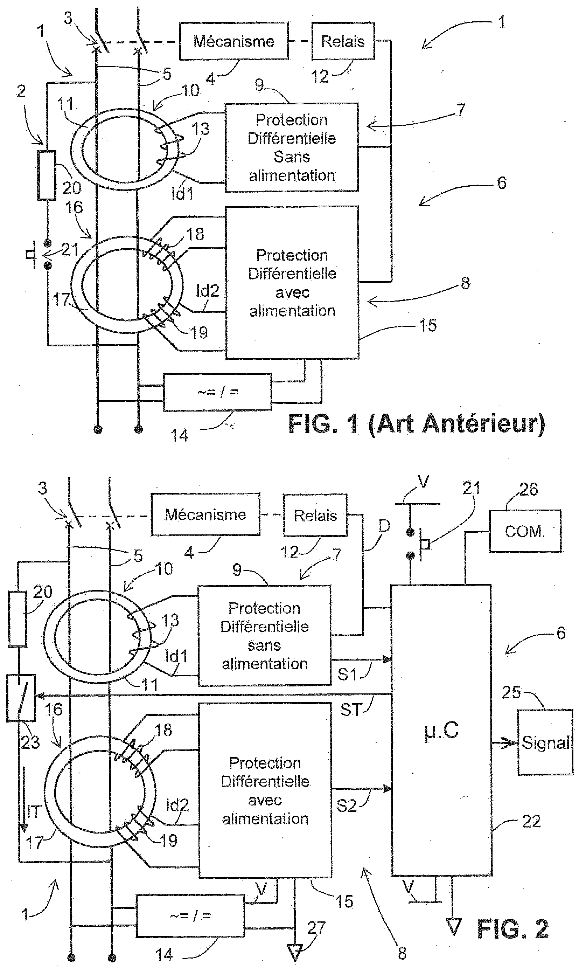

La figure 1 représente un schéma bloc d'un appareil électrique 1 comportant un dispositif de test 2 d'un dispositif de protection différentielle selon un mode de réalisation connu. Ledit appareil de protection électrique comporte des contacts principaux 3, un mécanisme 4 d'ouverture desdits contacts principaux 3, des conducteurs principaux 5 connectés en série avec lesdits contacts principaux et un dispositif de protection différentielle 6 ayant au moins deux chaines de protection différentielle. Une première chaine 7 de protection différentielle à propre courant ne nécessite pas d'alimentation électrique externe et une seconde chaine de protection différentielle 8 est à alimentation électrique. La première chaine 7 comporte un premier module électronique de traitement 9 connecté à un premier capteur de mesure 10 tel qu'un transformateur ou un tore de mesure à circuit magnétique 11. Ledit transformateur ou tore 10 fournit un signal ou un courant de mesure Id1 sur un enroulement secondaire 13 représentatif d'un courant différentiel Id circulant dans les lignes des conducteurs principaux 5. Le capteur 10 de mesure entoure l'ensemble des conducteurs principaux 5 et fourni un courant de mesure Id1 pour la protection différentielle en courant alternatif ou pulsé. Le courant de mesure Id1 fourni par le tore est suffisant pour faire fonctionner le premier module de protection 9 et pour actionner le relais de déclenchement 12. La seconde chaine de protection différentielle 8 nécessite une alimentation électrique 14. Cette alimentation 14 est généralement connectée sur des lignes des conducteurs principaux 5 et comporte un convertisseur de tension pour alimenter des circuits électroniques de traitement. La seconde chaine 8 comporte un second module électronique de traitement 15 connecté à un second capteur de mesure 16. Le capteur 16 est généralement un capteur complexe à circuit magnétique 17 comportant un enroulement d'excitation 18 et un enroulement de mesure 19 fournissant un second signal de mesure Id2. Le capteur 16 de mesure entoure aussi l'ensemble des conducteurs principaux 5 et fourni un courant de mesure Id2 pour la protection différentielle de tous types de courants aussi bien continus alternatifs ou pulsés. Le second circuit de traitement actionne également le relais de déclenchement 12 en cas de défaut différentiel.

Le test des chaines de protection se fait de manière classique en générant un courant différentiel entre l'amont et l'aval des capteurs de courant 10 et 16. Le dispositif de test 2 comporte une résistance 20 de limitation du courant de test et un bouton poussoir 21 de test connectés en série entre un premier conducteur de ligne amont et un second conducteur de ligne aval. Lorsque le test est commandé par l'action sur le bouton poussoir, un courant de défaut est généré et la chaine de traitement la plus concernée ou la plus rapide commande le déclenchement du relais 12 et l'ouverture des contacts 3 à travers le mécanisme 4. Ainsi, les deux chaines de protection ne sont pas testées lors d'un même test.

Un dispositif de protection différentielle selon l'invention comporte un test des fonctions de protection différentielle permettant de tester au moins deux chaines de protection différentielle lors d'un même test. La figure 2 représente un schéma bloc d'un appareil électrique bipolaire à deux lignes principales et comportant un dispositif de protection différentiel selon un premier mode de réalisation de l'invention. Le dispositif 6 de protection différentielle comporte une première chaine 7 de protection différentielle, une seconde chaine 8 de protection différentielle, un dispositif de test 2 pour tester les chaines de protection différentielle, et une unité de traitement 22 connectée à la seconde chaine 8 de protection différentielle.

Dans ce mode de réalisation, l'unité de traitement est connectée aussi à la première chaine 7 de protection différentielle pour déterminer l'état de la protection. Ainsi, l'unité de traitement 22 comporte une entrée pour recevoir un signal S1, fourni par un premier module de traitement 9 et représentatif de l'état de la protection de la première chaine de protection. Un second signal S2 représentatif du fonctionnement de la seconde chaine 7 est fourni à l'unité de traitement par un second module 15. L'unité de traitement 22 a une sortie fournissant un signal ST pour commander la circulation d'un signal de test IT pendant une durée prédéterminé T1 inférieure à un temps de non déclenchement TND de ladite première et de ladite seconde chaines de protection différentielle. L'unité de traitement comporte des modules pour contrôler l'évolution des chaines de protection, déterminer l'état du test et commander le déclenchement de l'ouverture d'un appareil électrique si le test est bon. Le circuit de test comporte un interrupteur 23 commandé par le signal ST de test pour faire circuler le courant de défaut différentiel détecté par les capteurs de courant des deux chaines de protection. Le dispositif de la figure 2 comporte un organe 21 de commande du test connecté à l'unité de traitement 22 pour commander manuellement un cycle de test.

L'unité de traitement comporte des modules pour déterminer l'état de ladite première chaine 7 et de ladite seconde chaine 8 de protection différentielle avant circulation d'un signal de test IT et pour commander le dispositif de test en fonction de l'état de la première et de la seconde chaine de protection différentielle. Après ou pendant la circulation du courant de test, les modules de l'unité de traitement contrôlent l'évolution des deux chaines de protection. Puis, si les évolutions des deux chaines sont conformes, ils signalent et ou commandent le déclenchement de l'ouverture d'un l'appareil. Sinon, une sortie de signalisation connectée à un indicateur 25 signale un test défaillant. Un circuit de communication 26 connecté à l'unité de traitement peut signaler aussi l'état de fonctionnement du test.

De préférence, le déclenchement est réalisé par une commande pendant un temps T4 de circulation d'un courant de test IT supérieur à un temps de déclenchement TD de la première chaine de traitement et/ou de la seconde chaine de traitement.

Une autre façon de commander le déclenchement est de commander directement le relais 12 par une sortie de l'unité de traitement. Sur la figure 2, le relais est commandé par un signal D directement par la première chaine de traitement ou par une sortie de l'unité de traitement. Dans ce cas, la seconde chaine de protection différentielle est aussi traitée par des modules numériques intégrés dans l'unité de traitement 22.

Dans ce mode de réalisation, la première chaine de protection différentielle 7 est une chaine dite à propre courant fonctionnant en courant de défaut alternatif ou pulsé et ne nécessitant pas une alimentation électrique pour son fonctionnement. La seconde chaine de protection différentielle 8 fonctionne pour des courants de défaut continu alternatifs ou pulsés et est alimentée par une alimentation électrique 14. Ladite unité de traitement 22 est de préférence associée à la seconde chaine de protection différentielle pour le traitement de la protection différentielle. L'alimentation 14 fournit l'énergie nécessaire pour faire fonctionner la seconde chaine de traitement et l'unité de traitement. Elle comporte une sortie de tension de référence 27 et au moins une sortie de ligne de tension d'alimentation V pour alimenter les circuits.

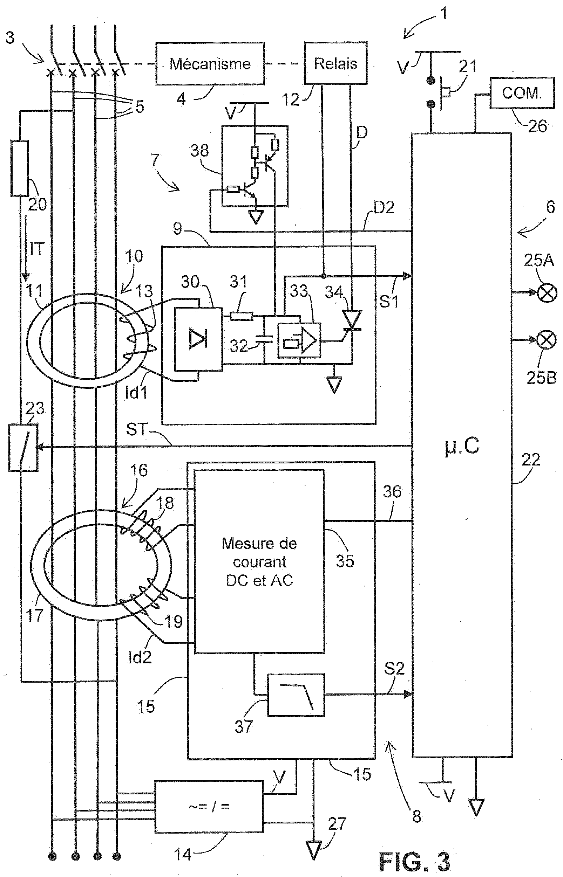

La figure 3 représente un schéma bloc d'un appareil électrique tétra polaire à quatre conducteurs de lignes comportant un dispositif de protection différentiel selon un second mode de réalisation de l'invention. La première chaine de protection différentielle 7 comporte dans le module 9 un redresseur 30 connecté à l'enroulement secondaire 13 du premier capteur 10, une résistance 31 connectée en sortie du redresseur et un condensateur 32 connecté à la résistance 31 et au redresseur. Le circuit résistance 31 et condensateur 32 effectue une temporisation pour le déclenchement de la première chaine de traitement. Le condensateur est connecté aussi à un comparateur 33 à seuil de tension pour commander un thyristor 34 ou un transistor de commande du relais 12 de déclenchement. L'énergie électrique accumulée dans le condensateur 32 est utilisée pour commander et alimenter le relais de déclenchement de la première chaine de traitement sans nécessiter d'alimentation supplémentaire. Seul le signal de mesure du premier capteur suffit à charger le condensateur 32 faisant office de temporisateur et de réserve d'énergie. Le condensateur 32 de par sa fonction de temporisation ou de filtrage a une tension représentative de la protection différentielle de la première chaine. Le condensateur 32 est avantageusement connecté à l'unité de traitement pour fournir le signal S1 représentatif de l'état de la première chaine de protection différentielle. Ainsi, le composant 32 de temporisation ou de filtrage est un condensateur utilisé aussi pour un stockage de l'énergie électrique de commande du relais de déclenchement.

La seconde chaine de traitement 8 comporte dans son module 15 un circuit de mesure de courant capable de mesurer des courants de défaut différentiel continus, alternatif ou pulsés par exemple des courants de fréquence allant de 0 Hz à plusieurs kHz. Ce circuit 35 envoie des signaux d'excitation sur un enroulement 18 du second capteur et mesure une valeur de courant sur un second enroulement 19. La fréquence de fonctionnement du circuit 35 est contrôlée par une connexion 36 avec l'unité de traitement. Le signal de mesure de la seconde chaine de traitement est filtré par un filtre passe bas 37 puis fourni par le signal S2 à l'unité de traitement.

L'unité de traitement commande la circulation d'un signal ou un courant de test pendant un temps T1 de non déclenchement TND, puis elle détermine l'état de fonctionnement des deux chaines de traitement et détermine l'état du test. Si le test est bon, un déclenchement est commandé sinon il y a un signalement d'un test défectueux représentatif d'une chaine ne répondant pas de manière attendue au test. En fin de test, un premier voyant 25A connecté à l'unité de traitement signale un défaut de test et un second voyant 25B signale un test conforme ou bon. Dans un dispositif plus complexe, une mesure d'un courant de défaut différentiel préalable ou l'état préalable de l'état des chaines de protection permet de déterminer le temps de génération du signal de test qui sera inférieur au temps de déclenchement. Un défaut avant test pourrait réduire le temps de non déclenchement. De même, une mémorisation de l'état de la protection différentielle avant le test et la restitution d'un état compatible après le test est utile si le test est utilisé pour de la signalisation de bon fonctionnement.

Le déclenchement du relais peut être réalisé par une commande directe du relais de déclenchement par l'unité de traitement. Sur le mode de réalisation de la figure 3, une sortie D2 de l'unité de traitement est connectée à un module 38 pour commander la charge du condensateur 32 utilisé aussi pour un stockage de l'énergie électrique de commande du relais 12 de déclenchement. Le déclenchement est fait alors de manière indirecte à travers le condensateur 32, le comparateur 33 et le thyristor 34.

Ainsi, un appareil de protection électrique selon un mode de réalisation de l'invention comporte des contacts principaux 3, un mécanisme 6 d'ouverture desdits contacts principaux 3, des conducteurs principaux connectés en série avec lesdits contacts principaux et un dispositif de protection différentielle ayant au moins deux chaines de protection différentielle, tel que défini ci-dessus.

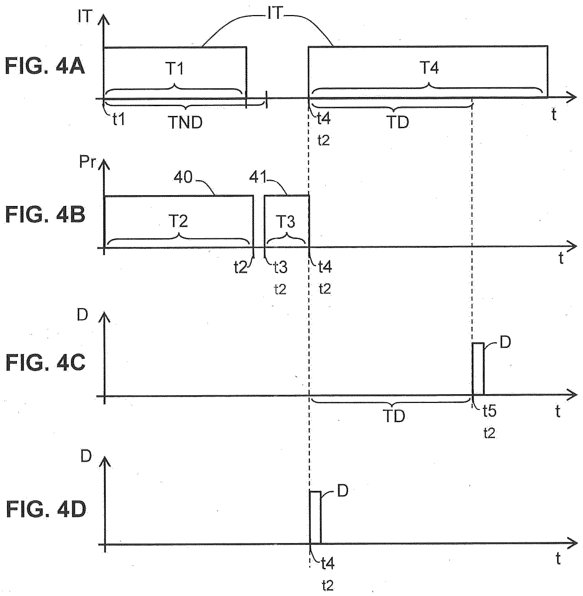

Les figures 4A à 4D représentent des chronogrammes de signaux dans un dispositif de protection différentiel selon des modes de réalisation de l'invention. Sur la figure 4A, à l'instant t1, un signal de test ST est commandé pendant une durée T1 inférieure à un temps de non déclenchement TND. Sur la figure 4B, un premier traitement des signaux des chaines de protection est réalisé notamment au début et à la fin d'un temps T2. Par exemple, à l'instant t1, il y a la détermination de l'état des chaines de protection avant ou au début du test et à un instant t2 la détermination de l'état des chaines de protection après le signal de test par un traitement 40. A un instant t3, commence l'analyse 41 de l'état du test pendant une durée T3 et à un instant t4 il y a une décision de signaler ou de déclencher l'ouverture d'un appareil. Le déclenchement peut se faire à travers le signal de test en envoyant un courant de test pendant un temps T4 supérieur au temps de déclenchement TD. L'appareil déclenchera par une chaine de protection au bout d'un temps de déclenchement TD à un instant t5 comme sur la figure 4C. Dans un autre mode de réalisation, le déclenchement peut se faire directement par une commande du relais comme sur la figure 4D.

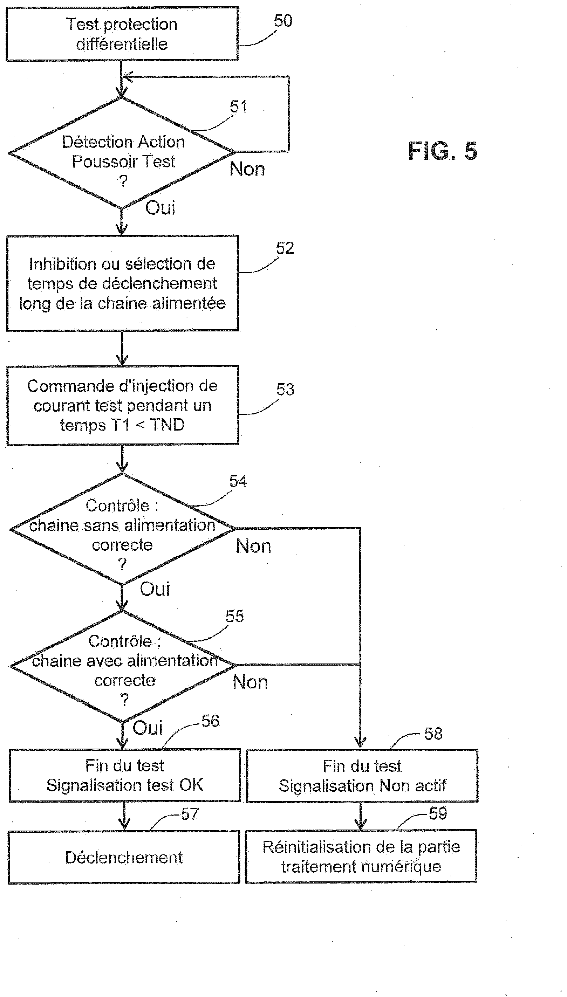

La figure 5 représente un premier organigramme de test de protection différentielle selon un mode de réalisation de l'invention. Le procédé de test de protection différentielle a une première chaine 7 de protection différentielle, une seconde chaine 8 de protection différentielle, et une unité de traitement 22. A une étape 50, une phase de test commence. Lorsque le test est prévu pour être manuel, le procédé comporte une étape de détection 51 de l'action sur organe de commande du test pour lancer cycle de test. L'organe de commande est généralement un bouton poussoir en face avant d'un appareil ou d'un dispositif de protection. Pour allonger le temps de non déclenchement le procédé comporte une étape 52 d'inhibition ou de sélection de déclenchement long de la seconde chaine de protection différentielle avant la commande de circulation ou d'injection dudit signal de test. Pour faciliter le traitement, ladite seconde chaine de protection différentielle nécessitant une alimentation électrique est associée à l'unité de traitement pour les fonctions de traitement. Puis, il y a une étape 53 de commande de la circulation d'un courant IT ou d'injection d'un signal de test de la protection différentielle pendant une durée prédéterminé T1 inférieure à un temps de non déclenchement TND de ladite première et de ladite seconde chaine de protection différentielle. Après circulation d'un signal de test, une étape 54 détermine l'état de ladite première chaine de protection différentielle et contrôle la conformité du fonctionnement de la protection. Si le test n'est pas bon ou pas concluant sur la première chaine, le procédé oriente vers un premier traitement de la fin du test pour gérer un test mauvais. Si le contrôle de l'étape 54 est bon, une étape 55 détermine l'état de ladite seconde chaine de protection différentielle et contrôle la conformité du fonctionnement de la protection. Si le test n'est pas bon ou pas concluant sur la seconde chaine, le procédé oriente vers le premier traitement de la fin du test pour gérer un test mauvais. Si le contrôle de l'étape 55 est bon, cela signifie que les deux chaines fonctionnent correctement. Le procédé oriente vers un second traitement de la fin du test pour gérer un test bon. Si le test est bon, une étape 56 signale la fin du test notamment avec un voyant et/ou une communication et une étape 57 provoque un déclenchement de l'ouverture d'un appareil électrique permettant de tester aussi la partie mécanique de l'appareil. Si le test est mauvais ou n'est pas conforme, une étape 58 signale la fin du test notamment avec un voyant et/ou une communication puis une étape 59 de réinitialisation réinitialise une partie numérique de l'unité de traitement. Sur l'organigramme de la figure 5, les étapes 54 et 55 font les deux fonctions groupées de détermination des états des protections différentielles et les deux contrôles de conformité. Cependant, ces fonctions peuvent être réalisées en des étapes distinctes, une étape pour la détermination des états et une étape pour le contrôle de conformité pour chaque chaine de protection.

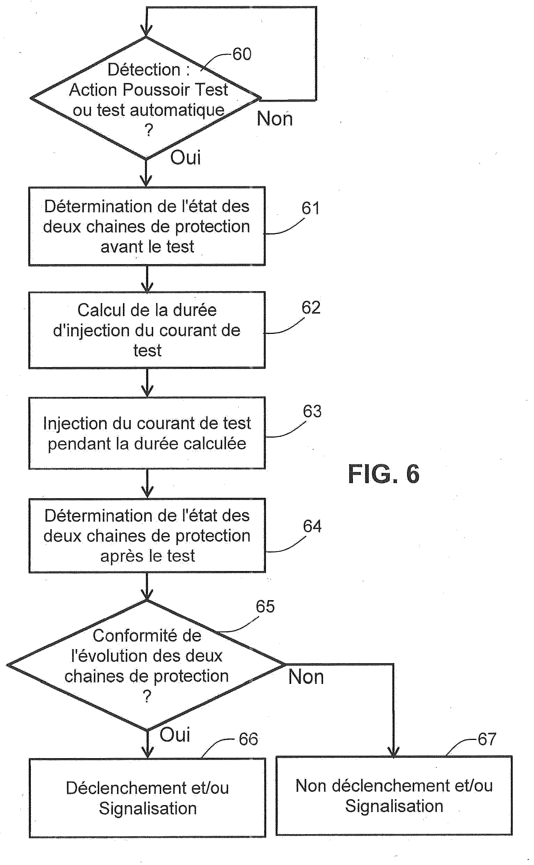

La figure 6 représente un second organigramme de test de protection différentielle selon un mode de réalisation de l'invention. Sur cet organigramme, une étape 60 détecte une action sur un bouton poussoir de lancement d'un test manuel ou un test automatique périodique. Une étape 61 détermine l'état de la première et de la seconde chaine de protection différentielle avant la circulation d'un signal ou courant de test. Puis une étape 62 calcule la durée d'injection ou circulation du courant de test. Dans ce cas, la durée dépend de l'état initial de la protection, notamment en cas de courant de défaut ou de courant de fuite résiduel. Le temps T1 de circulation du test peut être réduit pour garantir un non déclenchement de l'appareil pendant le test. A une étape 63, le courant de test circule pendant la durée préalablement calculée. Puis une étape 64 détermine l'état des deux chaines de protection différentielle après circulation du courant de test. Une étape 65 détermine la conformité de l'évolution des états des deux chaines de protection différentielle. Si le test est bon, une étape 66 commande le déclenchement d'un appareil électrique et/ou la signalisation d'un test correct. Si le test est mauvais ou non conforme, une étape 67 commande la signalisation d'un mauvais test.

Pendant la phase de test, notamment lors des étapes 54, 61, ou 64, de détermination de la première chaine de traitement, le procédé contrôle un composant 32 de temporisation ou de filtrage de ladite première chaine de protection différentielle ne nécessitant pas d'alimentation électrique.

Les tests de protection différentielle décrits ci-dessus s'appliquent aussi à des protections différentielles ayant plus de deux chaines de protection. Le nombre de deux chaines n'est pas une limitation mais une illustration des modes de réalisation préférés.

Les modes de réalisation décrits ci-dessus montrent un déclenchement du test par une action manuelle sur un bouton poussoir. Cette action est surtout utilisée pour provoquer un déclenchement de l'ouverture d'un appareil électrique. Cependant, le test peut aussi être déclenché périodiquement de manière automatique. Dans ce cas, la signalisation locale ou à distance sera préférée.

Dans les modes de réalisation décrits ci-dessus le test est fait par la génération d'un courant de défaut différentiel en dérivant un courant entre l'amont et l'aval des capteurs de courants. Cependant d'autres types de génération de signal de test sont possibles, notamment l'utilisation d'enroulements de test supplémentaires dans des capteurs de courant différentiel et/ou avec des générateurs alimentés et commandés par l'unité de traitement.

L'appareil électrique représenté sur la figure 1 est un appareil bipolaire avec deux lignes phase et neutre. Cependant, l'invention s'applique aussi à des appareils bipolaires ou tripolaires ou tétra polaires.

## Revendications

1. Procédé de test de protection différentielle ayant une première chaine (7) de protection différentielle, une seconde chaine (8) de protection différentielle, et une unité de traitement (22), le procédé comportant:
- une étape (53, 63) de commande de la circulation ou d'injection d'un signal de test de la protection différentielle pendant une durée (T1) prédéterminé inférieure à un temps (TND) de non déclenchement de ladite première et de ladite seconde chaines (7, 8) de protection différentielle,
- des étapes (54, 55, 64, 65) de détermination d'un état de ladite première et de ladite seconde chaine de protection différentielle après circulation d'un signal de test, de contrôle de la conformité de l'évolution des chaines de protection, et de détermination de l'état du test, et
- une étape (57, 59, 65, 67) de déclenchement ou de signalisation si le test est satisfaisant,
le procédé étant **caractérisé en ce que** ladite seconde chaine de protection différentielle nécessitant une alimentation électrique est associée à l'unité de traitement,
**en ce qu'**il comporte pendant la phase de test une étape (52) d'inhibition ou de sélection de déclenchement long de la seconde chaine de protection différentielle avant la commande de circulation ou d'injection dudit signal de test,
et **en ce qu'**il comporte une étape (51, 60) de détection de l'action sur un organe de commande du test pour lancer manuellement un cycle de test et/ou des étapes pour lancer automatiquement de manière périodique ledit cycle de test.

2. Procédé de test selon la revendication 1 **caractérisé en ce que** lors d'étapes de détermination de l'état de ladite première chaine de traitement différentielle, le procédé contrôle un composant (32) de temporisation ou de filtrage de ladite première chaine (7) de protection différentielle ne nécessitant pas d'alimentation électrique.

3. Procédé de test selon l'une quelconque des revendications 1 ou 2 **caractérisé en ce qu'**il comporte une étape (59) de réinitialisation d'une partie numérique de l'unité de traitement si l'état du test n'est pas conforme.

4. Dispositif (6) de protection différentielle comportant :
- une première chaine (7) de protection différentielle,
- une seconde chaine (8) de protection différentielle,
- un dispositif de test (2) pour tester lesdites chaines de protection différentielle, et
- une unité de traitement (22) connectée à des modules de la seconde chaine (8) de protection différentielle pour recevoir un signal (S2) représentatif du traitement de la dite seconde chaine, où ladite unité de traitement (22) :
- est connectée aussi à la première chaine (7) de protection différentielle pour recevoir un signal (S1) représentatif de la protection différentielle et pour déterminer l'état de la protection de ladite première chaine,
- comporte une sortie (ST) pour commander la circulation d'un signal ou d'un courant de test (IT) de test pendant une durée (T1) prédéterminé inférieure à un temps de non déclenchement (TND) de ladite première et de ladite seconde chaines (7, 8) de protection différentielle,
- comporte des modules (22, 54, 55, 64, 65) pour contrôler l'évolution des chaines de protection et détermine l'état du test, et
- commande le déclenchement (D) de l'ouverture d'un appareil électrique ou une signalisation si le test est bon, le dispositif étant
**caractérisé en ce que** la seconde chaine (8) de protection différentielle fonctionne pour des courants de défaut continus, alternatifs ou pulsés et est alimentée par une alimentation électrique (14), ladite unité de traitement (22) étant associée à ladite seconde chaine (8) de protection différentielle pour le traitement de la protection différentielle, et
**en ce qu'**il est configuré pour, pendant une phase de test implémenter une étape (52) d'inhibition ou de sélection de déclenchement long de la seconde chaine de protection différentielle avant la commande de circulation ou d'injection dudit signal de test, et
**en ce qu'**il comporte un organe (21) de commande du test connecté à l'unité de traitement (22) pour commander manuellement un cycle de test et/ou des étapes pour lancer automatiquement de manière périodique ledit cycle de test.

5. Dispositif de protection différentielle selon la revendication 4 **caractérisé en ce que** la première chaine (7) de protection différentielle est une chaine fonctionnant en courant de défaut alternatif ou pulsé ne nécessitant pas d'alimentation électrique pour son propre fonctionnement.

6. Dispositif de protection différentielle selon l'une quelconque des revendications 4 ou 5 **caractérisé en ce que** la première chaine (7) de protection différentielle comporte un composant (32) de temporisation ou de filtrage, ledit composant (32) étant connecté à l'unité de traitement (22) pour fournir un signal (S1) représentatif de l'état de la première chaine (7) de protection différentielle.

7. Dispositif de test selon l'une quelconque des revendications 4 à 6 **caractérisé en ce qu'**un déclenchement de l'ouverture d'un appareil est réalisé par une commande (ST) pendant un temps (T4) de circulation d'un courant (IT) de test supérieur à un temps (TD) de déclenchement de la première chaine (7) de protection ou de la seconde chaine (8) de protection.

8. Dispositif de test selon l'une quelconque des revendications 4 à 7 **caractérisé en ce qu'**un déclenchement de l'ouverture d'un appareil est réalisé par une commande (D) directe d'un relais (12) de déclenchement par ladite unité de traitement ou par une sortie (D2) de l'unité de traitement commandant la charge d'un condensateur (32) utilisé aussi pour un stockage de l'énergie électrique de commande dudit relais (12) de déclenchement.

9. Appareil de protection électrique comportant des contacts principaux (3), un mécanisme (6) d'ouverture desdits contacts principaux (3), des conducteurs principaux connectés en série avec lesdits contacts principaux et un dispositif de protection différentielle ayant au moins deux chaines de protection différentielle, **caractérisé en ce que** ledit dispositif de protection différentielle est un dispositif selon l'une des revendications 4 à 8 comportant des capteurs (10, 16) de courant pour lesdites chaines (7, 8) de protection différentielle entourant lesdits conducteurs principaux (3) et fournissant des signaux représentatifs de courants de défaut différentiel, ledit mécanisme (6) d'ouverture étant actionné par un relais de déclenchement (12) en cas de détection de défaut différentiel ou de test concluant desdites chaines de protection différentielle.

## Patentansprüche

1. Testverfahren für Differentialschutz mit einer ersten Kette (7) für Differentialschutz, einer zweiten Kette (8) für Differentialschutz, und einer Verarbeitungseinheit (22),
wobei das Verfahren umfasst:
- einen Schritt (53, 63) des Steuerns der Zirkulation oder des Einspritzens eines Testsignals des Differentialschutzes während einer vorbestimmten Dauer (T1), die kürzer ist als eine Nichtauslösezeit (TND) der genannten ersten und der genannten zweiten Kette (7, 8) für Differentialschutz,
- Schritte (54, 55, 64, 65) des Bestimmens eines Zustands der genannten ersten und der genannten zweiten Kette für Differentialschutz nach Zirkulation eines Testsignals, des Kontrollierens der Konformität der Entwicklung der Schutzketten, und des Bestimmens des Zustands des Tests, und
- einen Schritt (57, 59, 65, 67) des Auslösens oder Signalisierens, wenn der Test zufriedenstellend ist,
wobei das Verfahren **dadurch gekennzeichnet ist, dass** die genannte zweite Kette für Differentialschutz, die eine elektrische Versorgung benötigt, der Verarbeitungseinheit zugeordnet ist,
dass es während der Testphase einen Schritt (52) der Inhibierung oder der Auswahl einer langen Auslösung der zweiten Kette für Differentialschutz vor dem Steuern der Zirkulation oder des Einspritzens des genannten Testsignals umfasst,
und dass es einen Schritt (51, 60) der Aufrechterhaltung der Betätigung auf ein Steuerorgan des Tests, um manuell einen Testzyklus zu starten, und/oder Schritte umfasst, um automatisch periodisch den genannten Testzyklus zu starten.

2. Testverfahren nach Anspruch 1, **dadurch gekennzeichnet, dass** während Schritten des Bestimmens des Zustands der genannten ersten differentiellen Verarbeitungskette, das Verfahren eine Zeitverzögerungs- oder Filterkomponente (32) der genannten ersten Kette (7) für Differentialschutz kontrolliert, die keine elektrische Versorgung benötigt.

3. Testverfahren nach einem der Ansprüche 1 oder 2, **dadurch gekennzeichnet, dass** es einen Schritt (59) des Zurücksetzens eines digitalen Teils der Verarbeitungseinheit umfasst, wenn der Zustand des Tests nicht konform ist.

4. Vorrichtung (6) für Differentialschutz, umfassend:
- eine erste Kette (7) für Differentialschutz,
- eine zweite Kette (8) für Differentialschutz,
- eine Testvorrichtung (2) zum Testen der genannten Ketten für Differentialschutz, und
- eine Verarbeitungseinheit (22), die mit Modulen der zweiten Kette (8) für Differentialschutz verbunden ist, um ein Signal (S2) zu empfangen, das für die Verarbeitung der genannten zweiten Kette repräsentativ ist,
wobei die genannte Verarbeitungseinheit (22):
- auch mit der ersten Kette (7) für Differentialschutz verbunden ist, um ein Signal (S1) zu empfangen, das für den Differentialschutz repräsentativ ist, und um den Zustand des Schutzes der genannten ersten Kette zu bestimmen,
- einen Ausgang (ST) umfasst, um die Zirkulation eines Signals oder eines Teststroms (IT) des Tests während einer vorbestimmten Dauer (T1), die kürzer ist als eine Nichtauslösezeit (TND) der genannten ersten und der genannten zweiten Kette (7, 8) für Differentialschutz, zu steuern,
- Module (22, 54, 55, 64, 65) umfasst, um die Entwicklung der Schutzketten zu kontrollieren und den Zustand des Tests zu bestimmen, und
- die Auslösung (D) des Öffnens eines elektrischen Geräts oder eine Signalisierung steuert, wenn der Test gut ist, wobei die Vorrichtung
**dadurch gekennzeichnet ist, dass** die zweite Kette (8) für Differentialschutz für kontinuierliche, wechselnde oder pulsierende Fehlerströme funktioniert und durch eine elektrische Versorgung (14) gespeist wird, wobei die genannte Verarbeitungseinheit (22) der genannten zweiten Kette (8) für Differentialschutz für die Verarbeitung des Differentialschutzes zugeordnet ist,
und dass sie dazu konfiguriert ist, während einer Testphase einen Schritt (52) der Inhibierung oder der Auswahl einer langen Auslösung der zweiten Kette für Differentialschutz vor dem Steuern der Zirkulation oder des Einspritzens des genannten Testsignals zu implementieren,
und dass sie ein Organ (21) zum Steuern des Tests umfasst, das mit der Verarbeitungseinheit (22) verbunden ist, um manuell einen Testzyklus zu steuern, und/oder Schritte, um automatisch periodisch den genannten Testzyklus zu starten.

5. Vorrichtung für Differentialschutz nach Anspruch 4, **dadurch gekennzeichnet, dass** die erste Kette (7) für Differentialschutz eine Kette ist, die mit Wechsel- oder pulsierendem Fehlerstrom funktioniert und keine elektrische Versorgung für ihr eigenes Funktionieren benötigt.

6. Vorrichtung für Differentialschutz nach einem der Ansprüche 4 oder 5, **dadurch gekennzeichnet, dass** die erste Kette (7) für Differentialschutz eine Zeitverzögerungs- oder Filterkomponente (32) umfasst, wobei die genannte Komponente (32) mit der Verarbeitungseinheit (22) verbunden ist, um ein Signal (S1) bereitzustellen, das für den Zustand der ersten Kette (7) für Differentialschutz repräsentativ ist.

7. Testvorrichtung nach einem der Ansprüche 4 bis 6, **dadurch gekennzeichnet, dass** eine Auslösung des Öffnens eines Geräts durch eine Steuerung (ST) während einer Zeit (T4) der Zirkulation eines Teststroms (IT) realisiert wird, die länger ist als eine Auslösezeit (TD) der ersten Kette (7) für Schutz oder der zweiten Kette (8) für Schutz.

8. Testvorrichtung nach einem der Ansprüche 4 bis 7, **dadurch gekennzeichnet, dass** eine Auslösung des Öffnens eines Geräts durch eine direkte Steuerung (D) eines Auslöserelais (12) durch die genannte Verarbeitungseinheit oder durch einen Ausgang (D2) der Verarbeitungseinheit realisiert wird, der die Ladung eines Kondensators (32) steuert, der auch für eine Speicherung der elektrischen Steuerenergie des genannten Auslöserelais (12) verwendet wird.

9. Elektrisches Schutzgerät, umfassend Hauptkontakte (3), einen Mechanismus (6) zum Öffnen der genannten Hauptkontakte (3), Leiter Hauptleiter, die in Reihe mit den genannten Hauptkontakten verbunden sind, und eine Vorrichtung für Differentialschutz mit mindestens zwei Ketten für Differentialschutz,
**dadurch gekennzeichnet, dass** die genannte Vorrichtung für Differentialschutz eine Vorrichtung nach einem der Ansprüche 4 bis 8 ist, umfassend Stromsensoren (10, 16) für die genannten Ketten (7, 8) für Differentialschutz, die die genannten Hauptleiter (3) umgeben und Signale bereitstellen, die für differentielle Fehlerströme repräsentativ sind, wobei der genannte Öffnungsmechanismus (6) durch ein Auslöserelais (12) im Fall der Innehabung eines differentiellen Fehlers oder eines schlüssigen Tests der genannten Ketten für Differentialschutz betätigt wird.

## Claims

1. Method for testing differential protection having a first differential protection chain (7), a second differential protection chain (8), and a processing unit (22),
the method comprising:
- a step (53, 63) of commanding the circulation or injection of a test signal of the differential protection for a predetermined duration (T1) less than a non-tripping time (TND) of said first and of said second differential protection chains (7, 8),
- steps (54, 55, 64, 65) of determining a state of said first and of said second differential protection chain after circulation of a test signal, of checking the conformity of the evolution of the protection chains, and of determining the state of the test, and
- a step (57, 59, 65, 67) of tripping or of signaling if the test is satisfactory,
the method being **characterized in that** said second differential protection chain requiring an electrical power supply is associated with the processing unit,
**in that** it comprises during the test phase a step (52) of inhibiting or of selecting long tripping of the second differential protection chain before the command for circulation or injection of said test signal,
and **in that** it comprises a step (51, 60) of holding the action on a test control member to manually launch a test cycle and/or steps for automatically launching periodically said test cycle.

2. Test method according to claim 1 **characterized in that** during steps of determining the state of said first differential processing chain, the method controls a timing or filtering component (32) of said first differential protection chain (7) not requiring an electrical power supply.

3. Test method according to any one of claims 1 or 2 **characterized in that** it comprises a step (59) of resetting a digital part of the processing unit if the state of the test is not compliant.

4. Differential protection device (6) comprising:
- a first differential protection chain (7),
- a second differential protection chain (8),
- a test device (2) for testing said differential protection chains, and
- a processing unit (22) connected to modules of the second differential protection chain (8) to receive a signal (S2) representative of the processing of the said second chain,
where said processing unit (22):
- is also connected to the first differential protection chain (7) to receive a signal (S1) representative of the differential protection and to determine the state of the protection of said first chain,
- comprises an output (ST) for commanding the circulation of a signal or of a test current (IT) for testing for a predetermined duration (T1) less than a non-tripping time (TND) of said first and of said second differential protection chains (7, 8),
- comprises modules (22, 54, 55, 64, 65) for checking the evolution of the protection chains and determining the state of the test, and
- commands the tripping (D) of the opening of an electrical apparatus or a signaling if the test is good,
the device being **characterized in that** the second differential protection chain (8) operates for direct, alternating or pulsed fault currents and is powered by an electrical power supply (14), said processing unit (22) being associated with said second differential protection chain (8) for the processing of the differential protection,
and **in that** it is configured to, during a test phase implement a step (52) of inhibiting or of selecting long tripping of the second differential protection chain before the command for circulation or injection of said test signal,
and **in that** it comprises a test control member (21) connected to the processing unit (22) to manually command a test cycle and/or steps for automatically launching periodically said test cycle.

5. Differential protection device according to claim 4 **characterized in that** the first differential protection chain (7) is a chain operating with alternating or pulsed fault current not requiring an electrical power supply for its own operation.

6. Differential protection device according to any one of claims 4 or 5 **characterized in that** the first differential protection chain (7) comprises a timing or filtering component (32), said component (32) being connected to the processing unit (22) to provide a signal (S1) representative of the state of the first differential protection chain (7).

7. Test device according to any one of claims 4 to 6 **characterized in that** a tripping of the opening of an apparatus is carried out by a command (ST) for a time (T4) of circulation of a test current (IT) greater than a tripping time (TD) of the first protection chain (7) or of the second protection chain (8).

8. Test device according to any one of claims 4 to 7 **characterized in that** a tripping of the opening of an apparatus is carried out by a direct command (D) of a tripping relay (12) by said processing unit or by an output (D2) of the processing unit commanding the charge of a capacitor (32) also used for a storage of the electrical energy for commanding said tripping relay (12).

9. Electrical protection apparatus comprising main contacts (3), a mechanism (6) for opening said main contacts (3), conductors main connected in series with said main contacts and a differential protection device having at least two differential protection chains, **characterized in that** said differential protection device is a device according to one of claims 4 to 8 comprising current sensors (10, 16) for said differential protection chains (7, 8) surrounding said main conductors (3) and providing signals representative of differential fault currents, said opening mechanism (6) being actuated by a tripping relay (12) in the event of detention of differential fault or of conclusive test of said differential protection chains.
